# EUROPÄISCHE PATENTSCHRIFT

(11) **EP 1 603 378 B1**
(45) Veröffentlichungstag und Bekanntmachung des Hinweises auf die Patenterteilung: **29.12.2010**
(21) Anmeldenummer: 05005827.0
(22) Anmeldetag: 17.03.2005
(51) Int. Cl.: H05K 5/00, H05K 5/06, F16J 15/06

(54) **Elektronikgehäuse**
Electronic housing
Boîtier électronique

(30) Priorität: 04.06.2004 DE 102004028199
(43) Veröffentlichungstag der Anmeldung: 07.12.2005
(73) Patentinhaber: WABCO GmbH, 30453 Hannover (DE)
(72) Erfinder: Bornhof, Hans-Ulrich, 30938 Burgwedel (DE); Diekmeyer, Heinrich, 30890 Barsinghausen (DE); Eggebrecht, Detlev, 30173 Hannover (DE)
(74) Vertreter: Schrödter, Manfred

(56) Entgegenhaltungen:
- EP-A- 0 961 534
- EP-A- 1 022 507
- FR-A- 2 831 384

## Beschreibung

Die Erfindung bezieht sich auf ein Gehäuse, insbesondere für eine Elektronik oder eine Mechatronik, gemäß dem Oberbegriff des Patenanspruchs 1.

Derartige Gehäuse werden in hohen Stückzahlen gebaut und müssen daher kostengünstig herstellbar sein. Daneben muss aber auch, insbesondere beim Einsatz unter schwierigen Umweltbedingungen, wie z. B. in Kraftfahrzeugen, ein ausreichender Schutz der im Gehäuse angeordneten Elektronik oder Mechatronik gewährleistet sein. Insbesondere muss das unkontrollierte Eindringen von Wasser in das Gehäuse verhindert werden. Hierzu sind solche Gehäuse mit einer umlaufenden, statisch ausgebildeten, elastischen Dichtung versehen, welche ein Oberteil gegen ein Unterteil des Gehäuses im zusammengebauten Zustand abdichtet.

Daneben ist es aber auch vorteilhaft, wenn das Gehäuse eine kontrollierte Atmung zur umgebenden Atmosphäre gewährleisten kann. Hierdurch wird die Bildung von Kondenswasser im Inneren des Gehäuses bei wechselnden Umgebungstemperaturen verhindert. Weiter wird hierdurch bei Mechatroniken, welche auch mit einer Einspeisung von Druckluft in das Gehäuse arbeiten können, ein eventueller schädlicher Überdruck im Gehäuse verhindert.

Aus der DE 197 04 532 A1 sowie der EP 0 772 959 B1 sind wasserdichte Elektronikgehäuse bekannt, welche aus einem Oberteil und einem Unterteil bestehen, wobei die beiden Teile im zusammengebauten Zustand durch eine umlaufende Dichtung gegeneinander abgedichtet sind. Hierdurch wird das Eindringen von Schmutzwasser in das Gehäuse verhindert. Die bekannten Elektronikgehäuse besitzen jedoch keine Öffnung nach außen, die einen Atmungsvorgang ermöglichen könnten.

Aus der EP 0 961 534 A1 ist ein Elektronikgehäuse bekannt, welches zum Ausgleichen eines Druckunterschiedes zwischen dem Innenraum des Gehäuses und dem Außenraum des Gehäuses mit einer Membran ausgestattet ist. Ferner ist aus der FR 2 831 384 eine V-förmige Dichtung für ein Elektronikgehäuse bekannt, wobei allerdings keine Druckentlasungsvorrichtung vorgesehen ist.

Aus der DE 100 22 124 A1 ist weiter ein Gehäuse für ein elektronisches Steuergerät, insbesondere eine Mechatronik, bekannt, welche zur Entlüftung bzw. Belüftung eine Druckentlüftungs-Bohrung aufweist. Diese verhindert die Bildung von Kondenswasser im Gehäuse und hält weiterhin den Druck im Innenraum auf Atmosphärendruck. Auf diese Weise wird ein sonst möglicher Druckanstieg im Innenraum des Gehäuses bei einer leichten Undichtigkeit einer Druckluftzufuhr zu einem Drucksensor verhindert.

Das bekannte Gehäuse mit einer Druckentlastungs-Bohrung hat jedoch den Nachteil, dass durch die Bohrung eventuell Schmutzwasser in den Innenraum eindringen kann. Hierdurch können empfindliche Bauelemente beschädigt werden.

Der Erfindung liegt die Aufgabe zugrunde, ein Gehäuse, insbesondere für eine Elektronik oder eine Mechatronik, anzugeben, welches gegen das Eindringen von Schmutzwasser weitgehend geschützt ist, aber gleichzeitig eine schnelle Druckentlastung nach außen bei einem eventuellen Überdruck im Gehäuse zulässt.

Diese Aufgabe wird durch die im Patentanspruch 1 enthaltene Erfindung gelöst. Die Unteransprüche enthalten zweckmäßige Weiterbildungen.

Durch die erfindungsgemäße Integration einer Vorrichtung zur Druckentlastung in die umlaufende Dichtung zwischen Oberteil und Unterteil wird zum einen durch eine Labyrinth-Wirkung eine weitgehende Abdichtung des Gehäuses gegen äußeres Schmutzwasser erzielt, aber durch ein Lippenprofil auch ein schnelles Ablassen eines Überdruckes vom Innenraum ins Freie ermöglicht. Da damit eine besondere Vorrichtung (Überdruckventil) eingespart wird, ist das Gehäuse kostengünstig zu fertigen.

Die Erfindung wird im Folgenden anhand einer Zeichnung näher erläutert. Diese zeigt in
- Fig. 1: das Unterteil des erfindungsgemäßen Elek- tronikgehäuses mit eingelegter Ringdich- tung,
- Fig. 2: das Unterteil des Gehäuses ohne eingelegte Ringdichtung,
- Fig. 3: die Ringdichtung mit zwei integrierten Vorrichtungen zur Druckentlastung,
- Fig. 4: eine Vorrichtung zur Druckentlastung in vergrößerter Darstellung.
- Fig. 5: die Vorrichtung zur Druckentlastung aus Fig. 4 von unten betrachtet
- Fig. 6: einen Querschnitt durch die Ringdichtung im übrigen Bereich
- Fig. 7: einen Querschnitt durch die Ringdichtung im Bereich der Vorrichtung zur Druckentlastung,
- Fig. 8: das Elektronikgehäuse im zusammengebauten Zustand mit Ober- und Unterteil sowie eingelegter Ringdichtung.

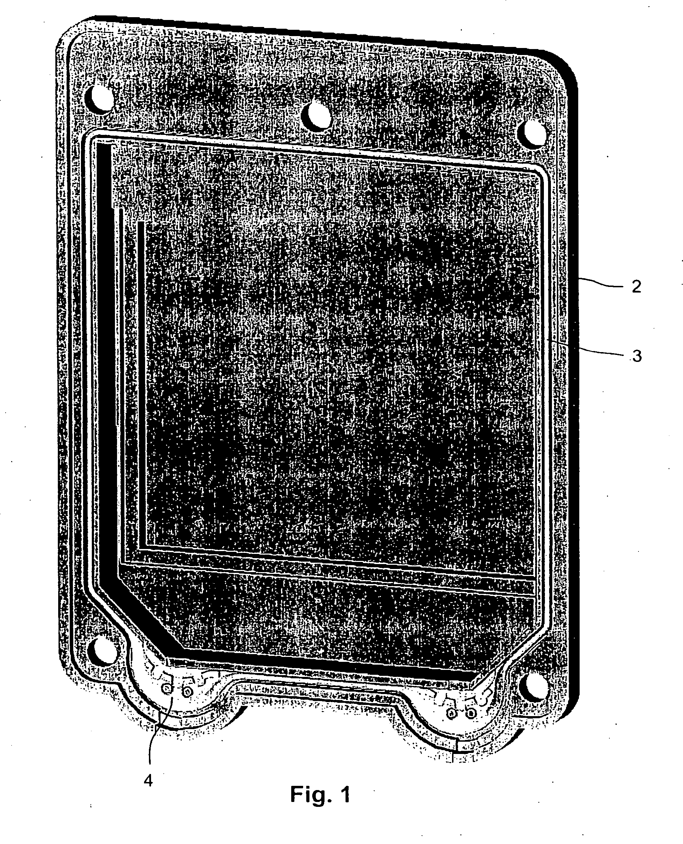

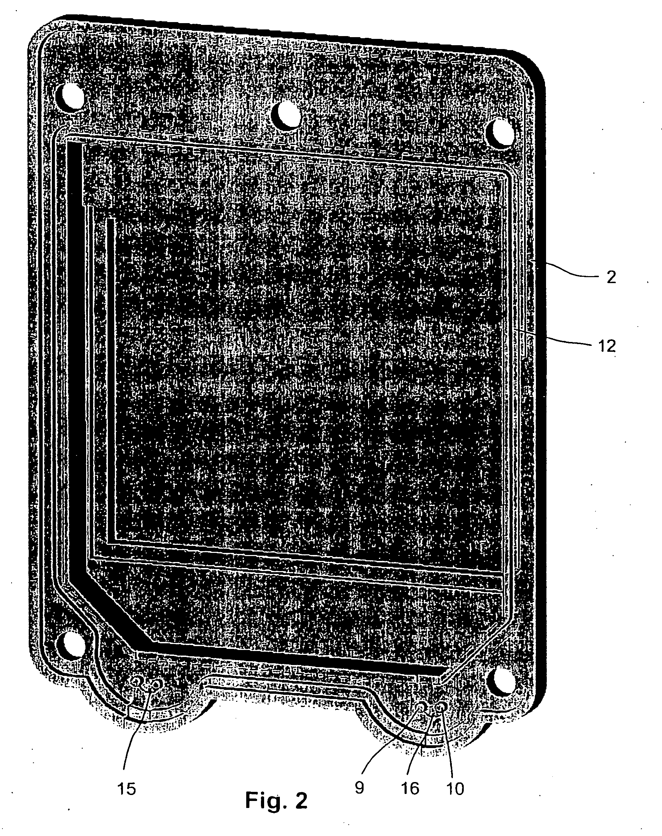

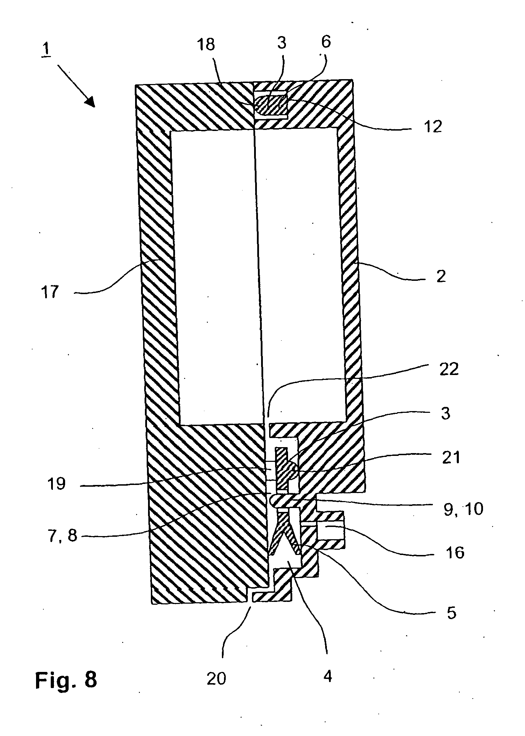

Die Fig. 1 zeigt eine perspektivische Darstellung eines Unterteils (2) eines Gehäuses (1) (vergl. Fig. 8) für eine Elektronik oder eine Mechatronik mit einer in eine Nut (12) (vgl. Fig. 2) eingelegten umlaufenden Dichtung (3).

Obwohl das Gehäuse (1) im Betrieb senkrecht stehend eingebaut wird (vergl. Fig.8), wobei die Vorrichtung zur Druckentlastung (4) unten angeordnet ist, wird im Folgenden vereinfachend von Ober- und Unterteil des Gehäuses gesprochen. Im montierten Zustand sind Oberund Unterteil seitlich angeordnet, so dass auch von Seitenteilen gesprochen werden kann.

Die Dichtung (3) ist aus einem elastischen Material, z.B. Gummi oder Kunststoff, gefertigt. Im Inneren des Gehäuses (1) sind in bekannter Weise mechanische, pneumatische und elektronische Bauelemente angeordnet (nicht dargestellt). Die Dichtung (3) weist zwei Vorrichtungen zur Druckentlastung (4) auf, die im folgenden noch näher erläutert werden.

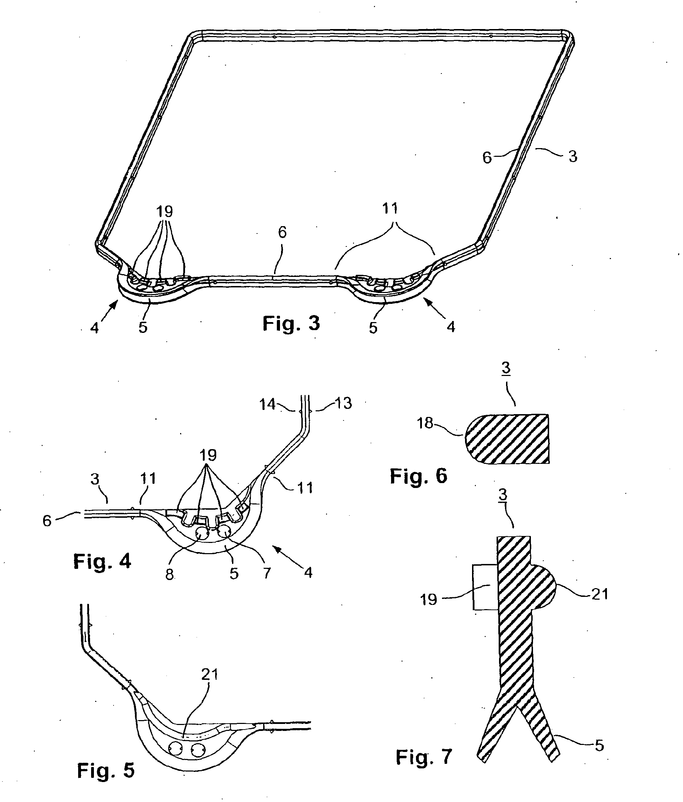

Die Fig. 2 zeigt das gleiche Unterteil (2) wie die Fig. 1, jedoch ohne eingelegte Dichtung (3). Man erkennt, dass die Nut (12) im unteren Teil des Gehäuses an zwei Stellen halbkreisförmig erweitert ist, an denen die beiden Vorrichtungen zur Druckentlastung (4) angeordnet sind. Zur Fixierung dieser Vorrichtungen dienen Haltezapfen (9, 10), die durch entsprechende kreisförmige Durchbrüche (7, 8) (vgl. Fig. 4) der Dichtung eingreifen.

Die Fig. 2 zeigt weiter zwei Beatmungsbohrungen (15, 16), welche sich im Unterteil (2) des Gehäuses befinden und von außen unterhalb der Vorrichtung zur Druckentlastung (4) bzw. seitlich in diese münden. Diese Bohrungen sind in bekannter Weise auch zur Prüfung der Dichtigkeit des Gehäuses zu verwenden. Sie ermöglichen weiter einen Atmungsvorgang bzw. einen Luftaustausch zwischen dem Innenraum des Gehäuses (1) und der umgebenden Atmosphäre bei wechselnden Umgebungstemperaturen.

In der Fig. 3 ist die umlaufende Dichtung (3) für sich dargestellt. Die Dichtung (3) besteht größtenteils aus einem statischen Teil (6), dessen Querschnitt in der Fig. 6 dargestellt ist.

Die Dichtung (3) besitzt weiter im unteren Teil zwei Vorrichtungen zur Druckentlastung (4), welche unten bzw. außen mit einem V-förmigen elastischen Lippenprofil (5) versehen sind (vergl. Fig. 7). Der Übergang (11) zwischen dem statischen Teil (6) der Dichtung (3) und dem Lippenprofil (5) ist stetig mit konstanter Profilhöhe ausgebildet. Weiter ist erkennbar, dass das Lippenprofil (5) doppelseitig ausgebildet ist (vgl. auch Fig. 7). Im statischen Teil (6) der Dichtung (3) ist diese dagegen rechteckig mit einer abgerundeten Schmalseite (18) ausgebildet (vgl. Fig. 6).

Am Innenrand der Dichtung im Bereich der Vorrichtungen zur Druckentlastung (4) sind mehrere Höcker (19) angeordnet, zwischen denen ein Luftdurchtritt möglich ist.

Die Fig. 4 zeigt eine der Vorrichtungen zur Druckentlastung (4) in vergrößerter Darstellung. Die Durchbrüche (7, 8) dienen, wie bereits gesagt, zur Aufnahme von Haltezapfen (9, 10) (siehe Fig. 2) und somit zur Fixierung der Vorrichtung zur Druckentlastung (4).

Zwischen den diskreten Höckern (19) ist ein Luftdurchtritt (Labyrinth-Dichtung) sowohl vom Gehäuse-Inneren nach außen als auch umgekehrt möglich. Die Höcker (19) dienen weiter zur Unterstützung einer Wulst (21) (siehe Fig. 5) auf der Rückseite der Dichtung und zur Fixierung der Vorrichtung zur Druckentlastung.

Die Dichtung (3) ist in ihrem statischen Teil weiter mit über ihren Umfang verteilten Noppen (13, 14) versehen, welche bei der Montage ein Herausfallen der Dichtung (3) aus der Nut (12) verhindern. Außerdem wird durch die Noppen (13, 14) eine Zentrierung der Dichtung (3) in der Nut (12) erreicht.

Die Fig. 5 zeigt die Vorrichtung zur Druckentlastung (4) aus der Fig. 4 von der Rückseite mit der Wulst (21).

Die Fig. 6 zeigt, wie oben bereits erwähnt, einen Querschnitt durch die Dichtung (3) im statischen Bereich. Hier ist die Dichtung (3) rechteckig mit einer abgerundeten Schmalseite (18) ausgebildet.

Die Fig. 7 zeigt einen Querschnitt durch die Dichtung (3) im Bereich einer Vorrichtung zur Druckentlastung (4). Wie man sieht, ist das Lippenprofil (5) doppelseitig ausgebildet. Es ist aber auch möglich, das Lippenprofil (5) nur einseitig auszubilden (nicht dargestellt). In diesem Fall ist die andere Seite als Wulst ausgebildet. Die Darstellung in Fig. 7 zeigt weiter einen der Höcker (19) und die gegenüberliegende Wulst (21).

Die Fig. 8 zeigt einen Querschnitt durch das Elektronikgehäuse (1) im zusammengebauten Zustand mit eingelegter Dichtung (3). Wie bereits gesagt, ist das Gehäuse senkrecht stehend angeordnet, wobei die Vorrichtungen zur Druckentlastung (4) unten liegen. Die umlaufende Dichtung (3) dichtet das Unterteil (2) des Gehäuses gegen ein Oberteil (17) des Gehäuses ab. Im Bereich einer Vorrichtung zur Druckentlastung (4) ist die Dichtung, wie bereits beschrieben, in ihrem äußeren Teil mit einem doppelseitigen Lippenprofil (5) versehen. Diese verhindert ein Eindringen von Schmutzwasser von außen, ermöglicht aber eine Druckentlastung von innen nach außen.

Wie bereits beschrieben, wird das Lippenprofil (5) durch mindestens einen Haltezapfen (9) fixiert. Die Haltezapfen (9) können auch am Oberteil (17) des Gehäuses (1) angebracht sein (nicht dargestellt).

Für Druck-Prüfungen sowie zum Luftaustausch ist das Unterteil des Gehäuses (1) mit mindestens einer Beatmungsbohrung (16) versehen, welche im Bereich des Lippenprofils (5) mündet. Die Beatmungsbohrungen (16) können auch im Oberteil (17) des Gehäuses angebracht sein (nicht dargestellt).

Das Gehäuse (1) besitzt mindestens im Bereich der Vorrichtung zur Druckentlastung (4) eine oder mehrere Stufen (20), wodurch das Eindringen von Schmutz in den Bereich des Lippenprofils (5) durch Ausbildung eines Labyrinths weiter erschwert wird. Die Stufen sind so ausgebildet und zueinander beabstandet, dass sie mit ihren einander zugewandten Seiten einen treppenförmigen Spalt begrenzen.

Im Inneren des Gehäuses (1) befinden sich eine oder mehrere Platinen zur Aufnahme von elektronischen und/oder mechatronischen Bauelementen (nicht dargestellt).

Anhand der Fig. 8 soll die Funktionsweise des erfindungsgemäßen Elektronik- bzw. Mechatronikgehäuses näher erläutert werden.

Falls sich im Inneren des Gehäuses (1) durch eine Undichtigkeit in einer pneumatischen Leitung ein Überdruck aufbauen sollte, kann dieser unter Zusammendrücken des elastischen Lippenprofils (5) leicht nach außen entweichen. Ein Eindringen von Luft in umgekehrter Richtung wird dagegen durch das gespreizte Lippenprofil (5) verhindert. Ein solches Eindringen von Außenluft zu Atmungszwecken wird jedoch durch die sehr engen Beatmungsbohrungen (16) ermöglicht.

Die Labyrinthwirkung des Gehäuses (1) gegen Eindringen von Schmutzwasser wird dadurch erzielt, dass das Wasser zunächst durch die enge Beatmungsbohrung (16) in den Raum zwischen Lippe (5) und Wulst (21) eindringen muss. Von dort aus kann es nur durch die engen Spalte zwischen den Haltezapfen (9,10) und den Durchbrüchen (7,8) in den benachbarten Hohlraum eindringen. Das Wasser muss dann weiter durch die Durchbrüche zwischen den Höckern (19) und danach durch einen engen Spalt (22) zwischen den beiden Gehäusehälften hindurch, um in den Gehäuse- Innenraum zu gelangen.

Das Gewicht des derart in das Innere des Gehäuses (1) eingedrungenen Wassers wirkt sodann in der Weise auf die beiden am tiefsten Punkt des Gehäuses angebrachten Lippen (5), dass diese sich zusammendrücken, und das Wasser wieder in die Umgebung freigegeben wird. Auf diese Weise ist ein schnelles Entwässern des Gehäuses gewährleistet.

Das Elektronikgehäuse kann auch so ausgebildet sein, dass es ein rahmenförmiges Mittelteil aufweist, das eine Platine enthält, auf welcher elektronische sowie mechatronische Bauteile aufgebracht sind (nicht dargestellt). Auf dieses Mittelteil sind dann die beiden in der Fig. 8 dargestellten Gehäusehälften bzw. Unterteil (2) und Oberteil (17) als Abschluss aufgesetzt. In diesem Fall kann die oben beschriebene erfindungsgemäße Dichtung (3) zweifach, also auf beiden Seiten des Mittelteils, angebracht sein.

## Patentansprüche

1. Elektronikgehäuse (1), insbesondere zur Aufnahme einer Elektronik oder einer Mechatronik, mit einem Oberteil (17) und einem Unterteil (2), oder mit mehreren zusammengebauten Gehäuseteilen, und mit mindestens einer umlaufenden, statisch ausgebildeten Dichtung (3), welche das Oberteil (17) gegen das Unterteil (2) oder gegen weitere Gehäuseteile im zusammengebauten Zustand abdichtet, **dadurch gekennzeichnet, dass** in die Dichtung (3) mindestens eine Vorrichtung zur Druckentlastung (4) integriert ist, welche mit dem Ober- und/oder dem Unterteil (17,2) oder mit weiteren Gehäuseteilen des Elektronikgehäuses (1) zusammenwirkt, wobei die Vorrichtung zur Druckentlastung (4) als zumindest in einem Teilstück der Dichtung (3) ausgebildetes elastisches Lippenprofil (5) realisiert ist, welches am Oberteil (17) und/oder am Unterteil (2) dichtend anliegt und ein durch Überdruck im Gehäuseinneren in eine Offenstellung bringbares Rückschlagventil bildet.

2. Gehäuse nach Anspruch 1, **dadurch gekennzeichnet, dass** es senkrecht montiert ist, wobei die Vorrichtung zur Druckentlastung (4) unten angeordnet ist.

3. Gehäuse nach Anspruch 1, **dadurch gekennzeichnet, dass** das Lippenprofil (5) V-förmig elastisch ausgebildet ist.

4. Gehäuse nach einem oder mehreren der Ansprüche 1 bis 3, **dadurch gekennzeichnet, dass** der Übergang (11) zwischen dem statischen Teil (6) der Dichtung (3) und dem Lippenprofil (5) stetig ausgebildet ist.

5. Gehäuse nach einem oder mehreren der Ansprüche 1 bis 4, **dadurch gekennzeichnet, dass** der Übergang (11) eine konstante Profilhöhe aufweist.

6. Gehäuse nach einem oder mehreren der Ansprüche 1 bis 5, **dadurch gekennzeichnet, dass** die Vorrichtung zur Druckentlastung (4) mindestens einen Durchbruch (7,8) aufweist, in den mindestens ein am Unterteil (2) des Gehäuses (1) angebrachter Haltezapfen (9,10) eingreift.

7. Gehäuse nach einem oder mehreren der Ansprüche 1 bis 6, **dadurch gekennzeichnet, dass** der Querschnitt des statischen Teils der Dichtung (3) rechteckig mit einer abgerundeten Schmalseite (18) ausgebildet ist.

8. Gehäuse nach einem oder mehreren der Ansprüche 1 bis 7, **dadurch gekennzeichnet, dass** die Dichtung (3) in eine Nut (12) des Unterteils (2) des Gehäuses (1) eingebettet ist.

9. Gehäuse nach einem oder mehreren der Ansprüche 1 bis 8, **dadurch gekennzeichnet, dass** die Dichtung (3) mehrere über ihren Umfang verteilte, seitlich hervorstehende Noppen (13,14) aufweist, die sich an den Seitenwänden der Nut (12) abstützen und die ein Herausfallen der Dichtung (3) aus der Nut (12) verhindern.

10. Gehäuse nach einem oder mehreren der Ansprüche 1 bis 9, **dadurch gekennzeichnet, dass** es mit einer oder mehreren Beatmungsbohrungen (15,16) versehen ist, welche seitlich in die Vorrichtung zur Druckentlastung (4) einmünden.

## Claims

1. Electronics housing (1), in particular for accommodating an electronics or mechatronics system, having an upper part (17) and a lower part (2), or having a plurality of assembled housing parts, and having at least one circumferential, static seal (3) which seals off the upper part (17) from the lower part (2) or from other housing parts in the assembled state, **characterized in that** at least one pressure-relief apparatus (4), which interacts with the upper part (17) and/or the lower part (2) or with other housing parts of the electronics housing (1), is integrated in the seal (3), with the pressure-relief apparatus (4) being realized as an elastic lip profile (5) which is formed at least in a component piece of the seal (3) and which bears in a sealing manner against the upper part (17) and/or against the lower part (2) and which forms a non-return valve which can be moved to an open position by excess pressure in the interior of the housing.

2. Housing according to Claim 1, **characterized in that** it is mounted in a vertical manner, with the pressure-relief apparatus (4) being arranged at the bottom.

3. Housing according to Claim 1, **characterized in that** the lip profile (5) is V-shaped and elastic.

4. Housing according to one or more of Claims 1 to 3, **characterized in that** the transition (11) between the static part (6) of the seal (3) and the lip profile (5) is continuous.

5. Housing according to one or more of Claims 1 to 4, **characterized in that** the transition (11) has a constant profile height.

6. Housing according to one or more of Claims 1 to 5, **characterized in that** the pressure-relief apparatus (4) has at least one aperture (7, 8) in which at least one retaining pin (9, 10), which is fitted to the lower part (2) of the housing (1), engages.

7. Housing according to one or more of Claims 1 to 6, **characterized in that** the cross section of the static part of the seal (3) is in the form of a rectangle with a rounded narrow side (18).

8. Housing according to one or more of Claims 1 to 7, **characterized in that** the seal (3) is embedded in a groove (12) in the lower part (2) of the housing (1).

9. Housing according to one or more of Claims 1 to 8, **characterized in that** the seal (3) has a plurality of laterally projecting knobs (13, 14) which are distributed over the circumference of said seal and which are supported on the side walls of the groove (12) and which prevent the seal (3) from falling out of the groove (12).

10. Housing according to one or more of Claims 1 to 9, **characterized in that** it is provided with one or more ventilation holes (15, 16) which open laterally into the pressure-relief apparatus (4).

## Revendications

1. Boîtier électronique (1), en particulier pour recevoir un système électronique ou mécatronique, comprenant une partie supérieure (17) et une partie inférieure (2), ou plusieurs parties de boîtier assemblées les unes aux autres, et au moins un joint d'étanchéité (3) périphérique réalisé de manière statique, qui étanchéifie la partie supérieure (17) par rapport à la partie inférieure (2) ou par rapport à d'autres parties de boîtier dans l'état assemblé, **caractérisé en ce que** dans le joint d'étanchéité (3) est intégré au moins un dispositif de détente de pression (4), qui coopère avec la partie supérieure et/ou la parti inférieure (17, 2) ou avec d'autres parties de boîtier du boîtier électronique (1), le dispositif de détente de pression (4) étant réalisé sous forme d'au moins un profilé formant lèvre élastique (5) réalisé dans une pièce partielle du joint d'étanchéité (3), lequel profilé s'applique de manière hermétique contre la partie supérieure (17) et/ou contre la partie inférieure (2) et forme une soupape antiretour pouvant être amenée dans une position d'ouverture par application d'une surpression à l'intérieur du boîtier.

2. Boîtier selon la revendication 1, **caractérisé en ce qu'**il est monté verticalement, le dispositif de détente de pression (4) étant disposé en-dessous.

3. Boîtier selon la revendication 1, **caractérisé en ce que** le profilé formant lèvre (5) est réalisé élastiquement en forme de V.

4. Boîtier selon l'une quelconque ou plusieurs des revendications 1 à 3, **caractérisé en ce que** la transition (11) est toujours réalisée entre la partie statique (6) du joint d'étanchéité (3) et le profilé formant lèvre (5).

5. Boîtier selon l'une quelconque ou plusieurs des revendications 1 à 4, **caractérisé en ce que** la transition (11) présente une hauteur de profilé constante.

6. Boîtier selon l'une quelconque ou plusieurs des revendications 1 à 5, **caractérisé en ce que** le dispositif de détente de pression (4) présente au moins un orifice (7, 8) dans lequel vient en prise au moins un tourillon de retenue (9, 10) monté sur la partie inférieure (2) du boîtier (1).

7. Boîtier selon l'une quelconque ou plusieurs des revendications 1 à 6, **caractérisé en ce que** la section transversale de la partie statique du joint d'étanchéité (3) est réalisée sous forme rectangulaire avec un petit côté arrondi (18).

8. Boîtier selon l'une quelconque ou plusieurs des revendications 1 à 7, **caractérisé en ce que** le joint d'étanchéité (3) est encastré dans une rainure (12) de la partie inférieure (2) du boîtier (1).

9. Boîtier selon l'une quelconque ou plusieurs des revendications 1 à 8, **caractérisé en ce que** le joint d'étanchéité (3) présente plusieurs boursouflures (13, 14) faisant saillie latéralement et réparties sur sa périphérie, lesquelles s'appuient sur les parois latérales de la rainure (12) et empêchent le joint d'étanchéité (3) de ressortir de la rainure (12).

10. Boîtier selon l'une quelconque ou plusieurs des revendications 1 à 9, **caractérisé en ce qu'**il est pourvu d'un ou de plusieurs alésages de ventilation (15, 16) qui débouchent latéralement dans le dispositif de détente de pression (4).
